# EUROPEAN PATENT APPLICATION

(11) **EP 1 884 695 A1**
(43) Date of publication of application: **06.02.2008**
(21) Application number: 06746563.3
(22) Date of filing: 17.05.2006
(51) Int. Cl.: F16K 24/00, F21S 8/10, F21V 31/03

(54) **GAS PERMEABLE MEMBER AND GAS PERMEABLE CASING USING THE SAME**

(30) Priority: 18.05.2005 JP 2005145140
(71) Applicant: NITTO DENKO CORPORATION, Ibaraki-shi, Osaka 567-8680 (JP)
(72) Inventor: FURUUCHI, Kouji, c/o NITTO DENKO CORPORATION, Ibaraki-shi, Osaka 5678680 (JP)
(74) Representative: Intes, Didier Gérard André
(86) International application number: PCT/JP2006/309860
(87) International publication number: WO 2006/123717

(57) **Abstract**

A ventilation member is provided that can ensure a long time until fogging is produced in the housing 51 and also can shorten the time until the produced fogging disappears when the interior of the housing is fogged. The ventilation member has: a gas permeable membrane (2), fixed to an opening of a housing (51), for allowing gas that passes through the opening to permeate therethrough; a support body (3) for supporting the gas permeable membrane (2); and a one-way valve (4) disposed so as to serve as an obstruction to permeation of the gas in a partial region of the gas permeable membrane (2). A portion of the one-way valve (4) is fixed to the gas permeable membrane (2) and/or the support body (3). At least a portion (B) of an end part of the one-way valve (4) can be deformed in a predetermined one direction by the pressure of the gas that permeates through the gas permeable membrane (2) in the one direction. The deformation of the end part (B) is reversible, and when the end part (B) is deformed in the one direction, the obstruction to the gas permeation by the one-way valve (4) is alleviated.

## Description

### TECHNICAL FIELD

The present invention relates to a ventilation member that is fixed to a housing for electrical components (typically automobile electrical components) and is for ensuring ventilation between the interior and the exterior of the housing and suppressing the entry of foreign matter into the interior of the housing. The invention also relates to a vented housing to which the ventilation member is fixed.

### BACKGROUND ART

Conventionally, ventilation members are attached to housings of electric appliances such as mobile telephones, cameras, and automobile electrical components, including lamps, pressure sensors, and ECUs (Electrical Control Units), in order to ensure ventilation between the interior and the exterior of the housings and to prevent the entry of foreign matter into the interior of the housings. Attaching such ventilation members to the housings makes it possible to prevent the entry of water, dust, and the like into the interior of the housings and at the same time to achieve the followings; the pressure change inside the housing associated with temperature change can be alleviated, sound can be transmitted between the interior and the exterior of the housing, and the gas produced in the interior of the housing can be discharged to the exterior of the housing.

One example of such a ventilation member is disclosed in JP 2001-143524A (Document 1). A ventilation member 101 disclosed in Document 1 has, as shown in Fig. 14, a tubular support body 103 and a closed-bottomed protective cover 104. A gas permeable membrane 102 is disposed on one end face of the tubular support body 103. The protective cover 104 is fitted to the support body 103 so as to cover the gas permeable membrane 102. The ventilation member 101 is fixed to a housing 105 so as to cover an opening 106 of the housing 105, and gas is allowed to permeate through the gas permeable membrane 102 so that ventilation between the interior and the exterior of the housing 105 is ensured. The protective cover 104 is disposed in order to prevent the breakage of the gas permeable membrane 102 caused by, for example, contact with foreign objects.

The conventional ventilation member 101, however, allows the gas inside the housing 105 and the gas outside the housing 105 to be in communication with each other via the gas permeable membrane 102 at all times, and therefore, water vapor outside the housing 105 may enter the interior of the housing 105, producing water droplets on the inner surface of the housing 105 (i.e., fogging the inner surface of the housing 105). For example, when the housing is a lamp as one type of automobile electrical components, the water droplets (fogging) can reduce the light intensity of the light emitted from the lamp. Such fogging is apt to occur by turning off the lamp when the air temperature is low and the humidity of the exterior the housing is high (for example, when it is raining or snowing in winter). From the viewpoint of improving the automobile's safety, a ventilation member that can prolong the time until the fogging is produced is desirable. Also desirable is a ventilation member that allows the fogging to disappear quickly after turning on the lamp, for example, even if the fogging is produced. For the ventilation members used for other kinds of housings, similar characteristics have been desired.

It is possible to delay the generation of water droplets (production of fogging) by reducing the gas permeable area of the gas permeable membrane provided for the ventilation member to decrease the amount of the water vapor that enters the interior of the housing per unit time; however, in this method, the amount of the water vapor discharged to the exterior of the housing per unit time also decreases simultaneously, and therefore, once the water droplets are generated (the fogging is produced), it takes a long time before the droplets disappear (i.e., until fogging disappears). In addition, when electricity is passed through an electrical component, such as a lamp, in which the interior of the housing heats up during electricity supply, in the state where fogging has been produced therein, the water droplets are heated and water vapor is produced; however, the ventilation member provided with a gas permeable membrane having a small gas permeable area requires a long time to release the produced vapor to the exterior of the housing.

### DISCLOSURE OF THE INVENTION

It is an object of the present invention to provide a ventilation member that can ensure a long time until fogging is produced in the housing and that can shorten the time until the produced fogging disappears when the interior of the housing has been fogged up, by allowing the ventilation member to have a structure that has not been available before. It is also an object of the invention to provide a vented housing using the just-mentioned ventilation member.

A ventilation member according to the present invention includes: a gas permeable membrane, fixed to an opening of a housing, for allowing gas that passes through the opening to permeate therethrough; a support body for supporting the gas permeable membrane; and a one-way valve disposed so as to serve as an obstruction to permeation of the gas in a partial region of the gas permeable membrane. In the ventilation member according to the present invention, a portion of the one-way valve is fixed to at least one selected from the gas permeable membrane and the support body. At least a portion of an end part of the one-way valve can be deformed in a predetermined one direction by the pressure of the gas that permeates through the gas permeable membrane in the predetermined one direction, and the deformation of the at least a portion of the end part is reversible. When the at least a portion of the end part is deformed in the one direction, the obstruction to the permeation of the gas by the one-way valve is alleviated.

A vented housing according to the present invention is a vented housing having an opening for allowing gas to pass therethrough, and includes a ventilation member as set forth in claim 1. In the vented housing according to the present invention, the ventilation member is fixed to the opening in such a manner that the direction in which at least a portion of an end part of the one-way valve of the ventilation member is deformed is a direction in which the gas passes therethrough from an interior to an exterior of the housing.

The present invention makes it possible to ensure a long time until fogging is produced in the housing and to also shorten the time until the produced fogging disappears when the interior of the housing is fogged, by controlling the rate at which gas moves from the interior to the exterior of the housing and the rate at which gas moves from the exterior to the interior of the housing with the use of the one-way valve that serves as an obstruction to the gas permeation in a partial region of the gas permeable membrane.

### BRIEF DESCRIPTION OF THE DRAWINGS

[Fig. 1A] Fig. 1A is a cross-sectional view schematically illustrating one example of a ventilation member according to the present invention.
[Fig. 1B] Fig. 1B is a plan view of the ventilation member shown in Fig. 1A.
[Fig. 2] Fig. 2 is a schematic view for illustrating the operation of the one-way valve in the ventilation member shown in Figs. 1A and 1B.
[Fig. 3] Fig. 3 is a cross-sectional view schematically illustrating another example of the ventilation member according to the present invention.
[Fig. 4A] Fig. 4A is a cross-sectional view schematically illustrating still another example of the ventilation member according to the present invention.
[Fig. 4B] Fig. 4B is a plan view of the ventilation member shown in Fig. 4A.
[Fig. 5] Fig. 5 is a cross-sectional view schematically illustrating yet another example of the ventilation member according to the present invention.
[Fig. 6A] Fig. 6A is a cross-sectional view schematically illustrating a further example of the ventilation member according to the present invention.
[Fig. 6B] Fig. 6B is a plan view for illustrating a state in which the valve in the ventilation member shown in Fig. 6A is open.
[Fig. 7A] Fig. 7A is a cross-sectional view schematically illustrating a further example of the ventilation member according to the present invention.
[Fig. 7B] Fig. 7B is a plan view of the ventilation member shown in Fig. 7A.
[Fig. 8] Fig. 8 is a cross-sectional view schematically illustrating a further example of the ventilation member according to the present invention.
[Fig. 9A] Fig. 9A is a cross-sectional view schematically illustrating a further example of the ventilation member according to the present invention.
[Fig. 9B] Fig. 9B is a plan view of the ventilation member shown in Fig. 9A.
[Fig. 10A] Fig. 10A is a cross-sectional view schematically illustrating a further example of the ventilation member according to the present invention.
[Fig. 10B] Fig. 10B is a plan view of the ventilation member shown in Fig. 10A.
[Fig. 11] Fig. 11 is a schematic cross-sectional view for illustrating one example of how to fix the ventilation member, according to the present invention, to a housing.
[Fig. 12] Fig. 12 is a schematic cross-sectional view for illustrating another example of how to fix the ventilation member, according to the present invention, to the housing.
[Fig. 13] Fig. 13 is a cross-sectional view schematically illustrating a further example of the ventilation member according to the present invention.

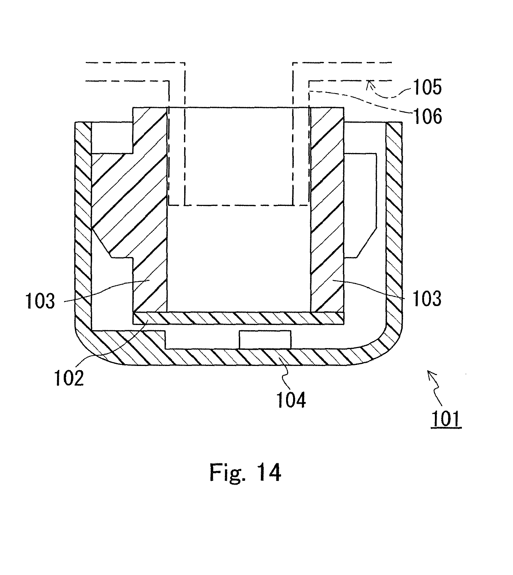

[Fig. 14] Fig. 14 is a cross-sectional view schematically illustrating one example of a conventional ventilation member.

### BEST MODE FOR CARRYING OUT THE INVENTION

Hereinbelow, preferred embodiments of the present invention are described with reference to the drawings. In the following description, the same parts are designated by the same reference numerals and repetitive description thereof may be omitted.

A ventilation member according to the present invention will be described.

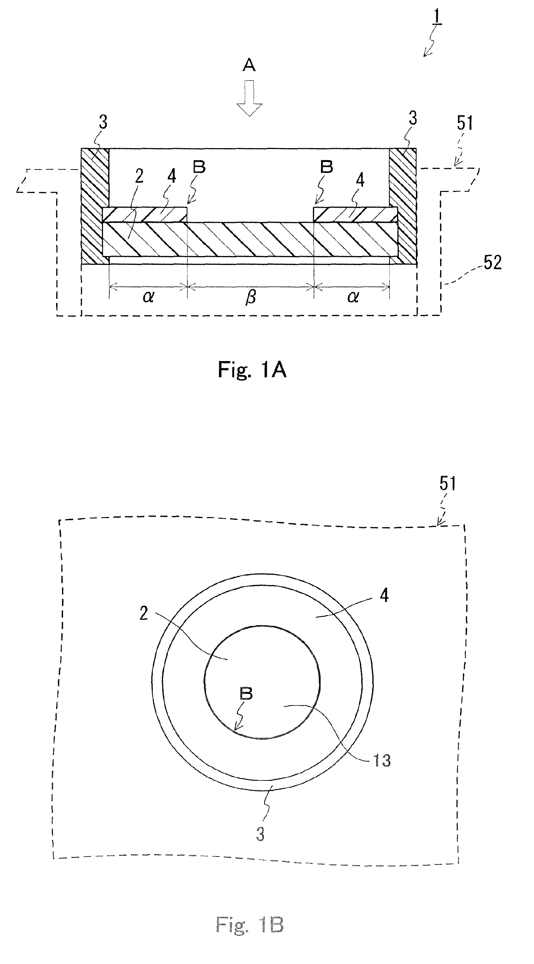

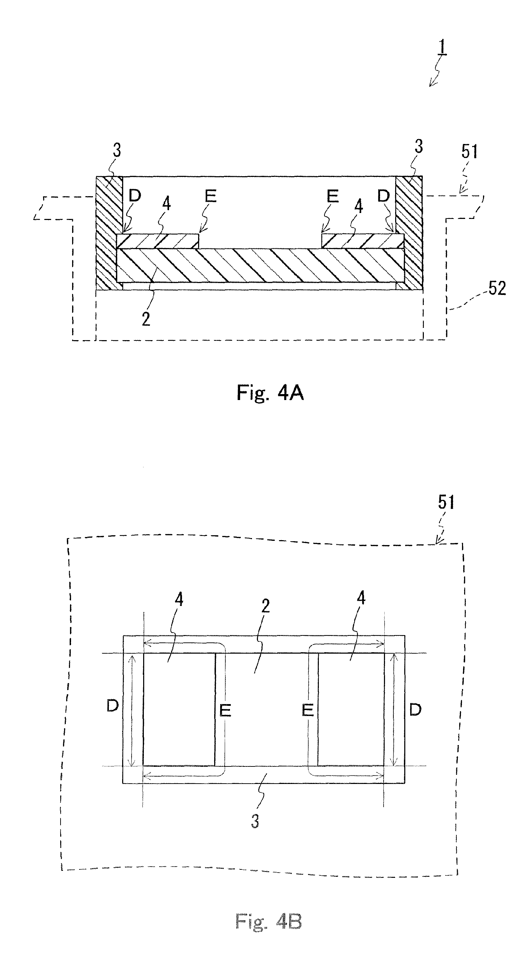

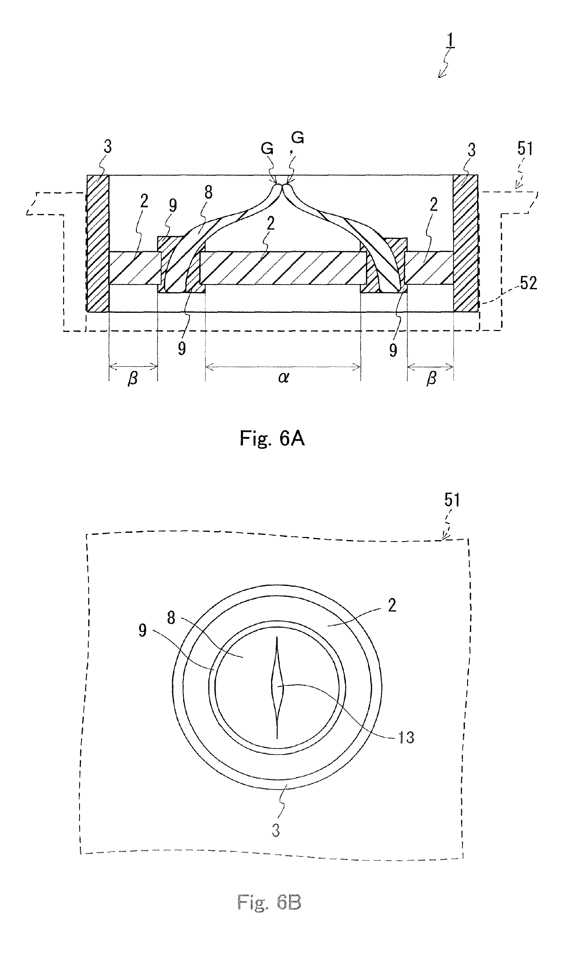

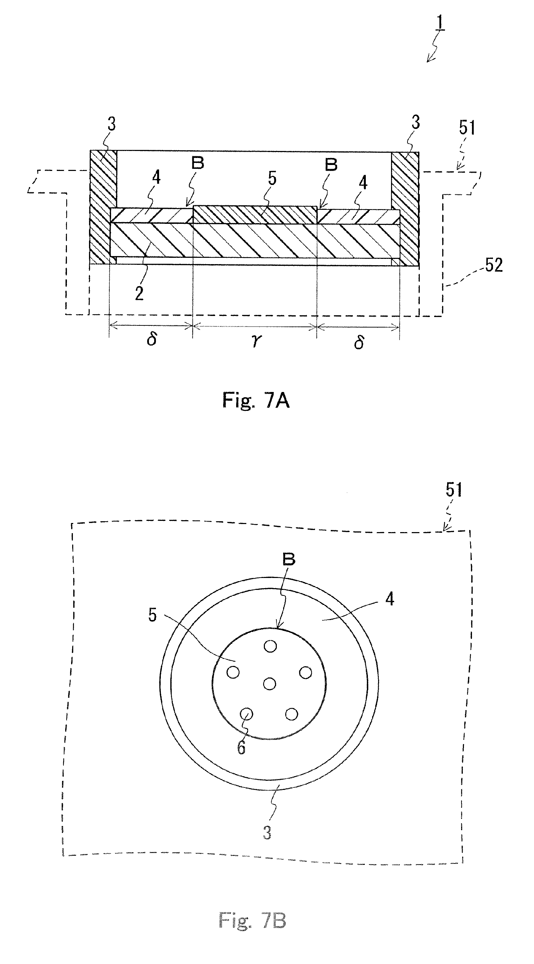

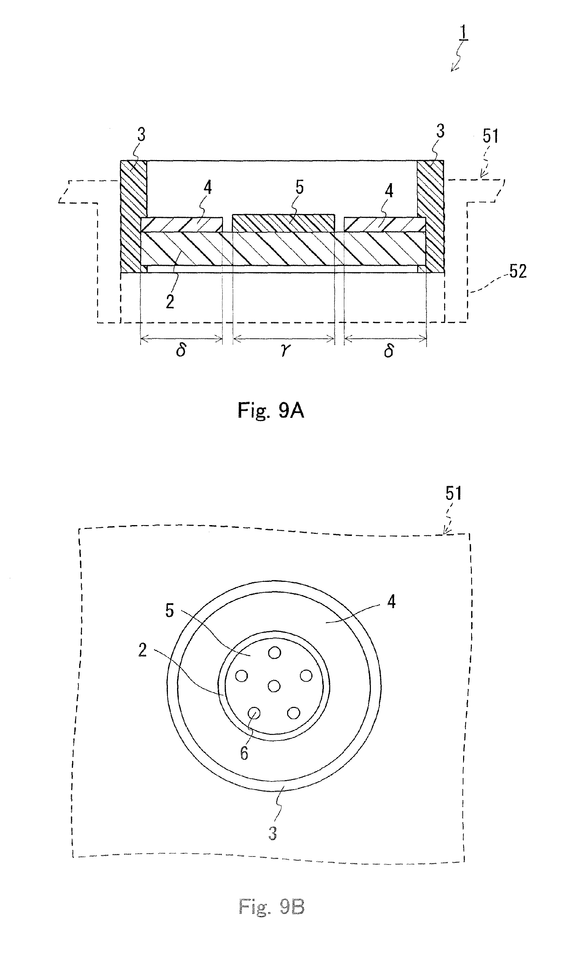

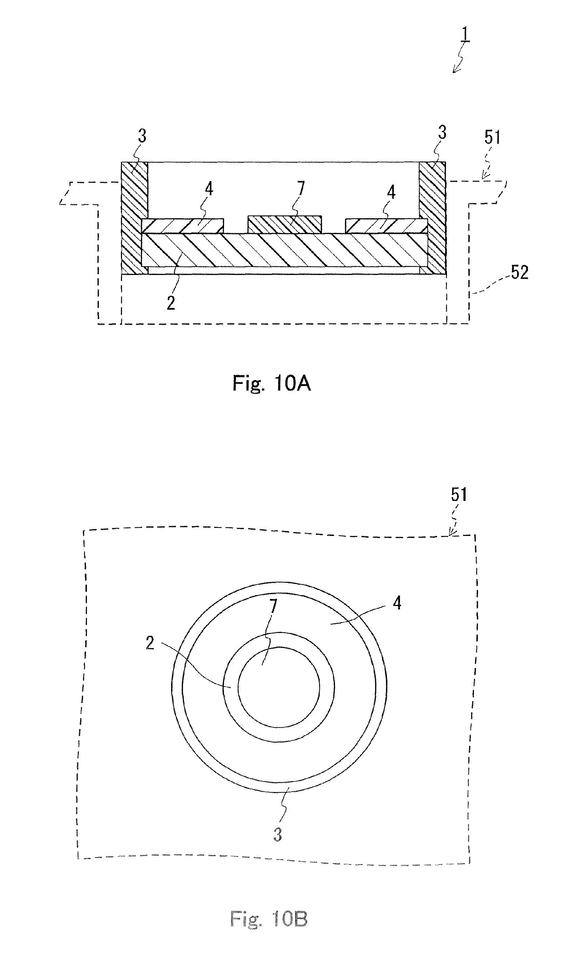

A ventilation member 1 shown in Figs. 1A and 1B is provided with a gas permeable membrane 2 and a support body 3 for supporting the gas permeable membrane 2. The support body 3 is inserted in and fixed to an opening 52 of a housing 51. The ventilation member 1 has, as the one-way valve, a membranous valve 4 disposed in contact with a surface of the gas permeable membrane 2 so as to cover a portion of the gas permeable membrane 2. The gas permeable membrane 2 is supported by the support body 3 at its outer peripheral edge, and the membranous valve 4 is fixed to the support body 3 at an outer peripheral edge of the membranous valve 4 that is in contact with the support body 3. The ventilation member 1 is fixed to the housing 51 so that the membranous valve 4 is positioned toward the outside of the housing 51 relative to the gas permeable membrane 2. By the pressure P_{A} of the gas that permeates through the gas permeable membrane 2 in a direction from the interior to the exterior of the housing 51, an inner peripheral edge (the end part B shown in Figs. 1A and 1B) of the membranous valve 4 can be detached away from the surface of the gas permeable membrane 2 in the just-mentioned direction. It should be noted that Fig. 1B is a view in which the ventilation member 1 shown in Fig. 1A is viewed from the upper face (in other words, viewed in the direction along the arrow A in Fig. 1A). The same relationship also exists between Fig. 4A and Fig. 4B, between Fig. 6A and Fig. 6B, between Fig. 7A and Fig. 7B, between Fig. 9A and Fig. 9B, and between Fig. 10A and Fig. 10B.

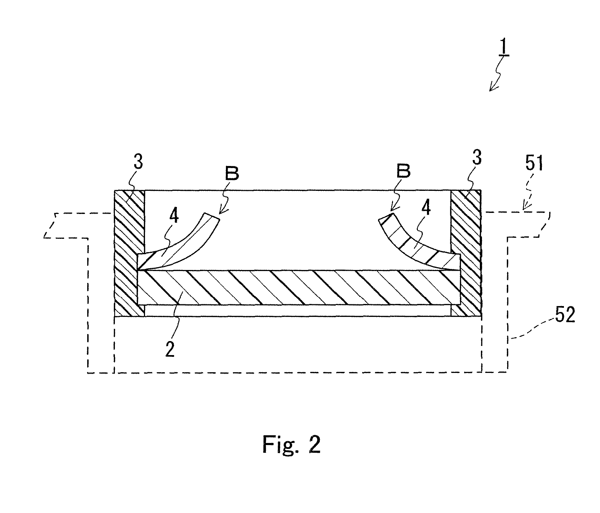

In the ventilation member 1, the membranous valve 4 works as an obstruction to permeation of the gas in region α of the gas permeable membrane 2. Here, when the pressure P_{A} becomes equal to or higher than a certain value (that is, when the pressure P_{A} becomes equal to or higher than a threshold value P_{T}), the inner peripheral edge (end part B) of the membranous valve 4 comes off from the surface of the gas permeable membrane 2, as shown in Fig. 2, whereby the membranous valve 4 opens in the direction in which gas permeates through the gas permeable membrane 2 from the interior to the exterior of the housing 51. As the membranous valve 4 opens, the above-mentioned obstruction in the region α is alleviated. The deformation of the end part B of the membranous valve 4 is reversible. Therefore, when the pressure P_{A} decreases or when the pressure P_{B} of the gas that permeates through the gas permeable membrane 2 in the direction from the exterior to the interior of the housing 51 acts on the membranous valve 4, the membranous valve 4 returns to the state shown in Fig. 1A (i.e., the membranous valve 4 closes).

By employing such a structure, it is possible to increase the rate at which gas is discharged from the interior to the exterior of the housing 51 (i.e., gas discharge rate) while keeping the rate at which the gas is introduced from the exterior to the interior of the housing 51 (i.e., gas introduction rate) to be small. Thus, the ventilation member is configured to ensure a long time until fogging is produced in the housing 51 and to shorten the time until the produced fogging disappears when the interior of the housing 51 is fogged. In addition, the ventilation member is configured to ensure a long time until fogging is produced in the housing 51 and moreover to prevent an excessive pressure increase in the housing 51.

The structure and configuration of the membranous valve 4 of the ventilation member 1, including the shape thereof, are not particularly limited as long as the following conditions are met:
- A portion of the membranous valve 4 is fixed to at least one selected from the gas permeable membrane 2 and the support body 3;
- By the pressure P_{A} of the gas that permeates through the gas permeable membrane 2 in a predetermined one direction, at least a portion of an end part of the membranous valve 4 can be detached away from the surface of the gas permeable membrane 2 in the predetermined one direction; and
- By a decrease of the above-mentioned pressure P_{A} or by the pressure P_{B} of the gas that permeates through the gas permeable membrane 2 in the opposite direction to the above-mentioned predetermined one direction, the membranous valve 4 can return to the state before the membranous valve 4 has been detached away from the surface of the gas permeable membrane 2 (that is, the deformation of the membranous valve 4 by the pressure P_{A} is reversible).

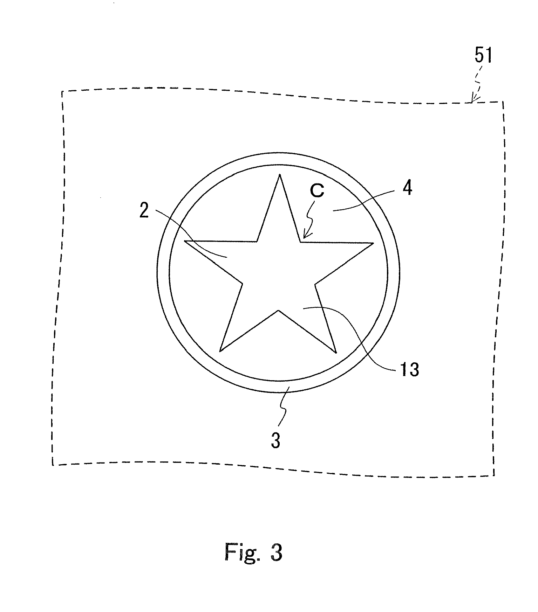

For example, a membranous valve 4 of a ventilation member 1 shown in Fig. 3 is fixed to a support body 3 at its outer peripheral edge that is in contact with the support body 3, as in the example shown in Figs. 1A and 1B, and its inner peripheral edge (end part C shown in Fig. 3) can be detached away from the surface of a gas permeable membrane 2 by the pressure P_{A}.

A membranous valve 4 of a ventilation member 1 shown in Fig. 4A and 4B has a rectangular shape, and a portion of its outer peripheral edge (end part D shown in Figs. 4A and 4B) that is in contact with a support body 3 is fixed to the support body 3. A portion of the outer peripheral edge (end part E shown in Figs. 4A and 4B) of the membranous valve 4 that is not fixed to the support body 3 can be detached away from the surface of a gas permeable membrane 2 by the pressure P_{A}.

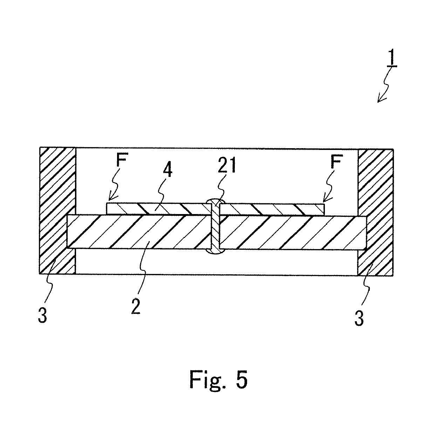

A membranous valve 4 of a ventilation member 1 shown in Fig. 5 has a disk-like shape, and it is fixed to a gas permeable membrane 2 with a securing member 21, such as a pin. The outer peripheral edge (end part F shown in Fig. 5) of the membranous valve 4 can be detached away from the surface of the gas permeable membrane 2 by the pressure P_{A}.

The ventilation member 1 shown in Figs. 1A and 1B as well as that shown in Fig. 3 may be described as a ventilation member 1 in which the membranous valve 4 is disposed in such a manner that an opening surrounded by the membranous valve 4 is formed in the surface of the gas permeable membrane 2. The ventilation member 1 in which such an opening is formed allows the membranous valve 4 to have a large area, and therefore, it is capable of further increasing the ratio A of the gas discharge rate to the gas introduction rate (ratio A = "gas discharge rate" / "gas introduction rate"). Moreover, since the membranous valve 4 can be fixed to the support body 3 at its outer peripheral edge, the durability of the membranous valve 4 can be improved.

A threshold value P_{T} of the pressure P_{A} at which the membranous valve 4 is detached away from the surface of the gas permeable membrane 2 can be controlled by adjusting or selecting, for example, the thickness, area, shape, and/or securing method of the membranous valve 4. The values P_{A} and P_{B} at which the membranous valve 4 returns to the state before it is detached away from the surface of the gas permeable membrane 2 may be controlled likewise. The thickness of the membranous valve 4 is usually within the range of from 1 µm to 100 µm, preferably within the range of from 2 µm to 50 µm. When the thickness of the membranous valve 4 is within these ranges, the operability of the membranous valve 4 can be kept maintained well. It should be noted that the threshold value P_{T} may be a value within a predetermined range, not just at one specified point.

The method for fixing the membranous valve 4 to at least one selected from the gas permeable membrane 2 and the support body 3 is not particularly limited, and the membranous valve 4 may be fixed with the use of such techniques as heat-bonding, ultrasonic welding, and adhesive bonding. As shown in Fig. 5, it is also possible to fix the membranous valve 4 using the securing member 21. The membranous valve 4 may be fixed to the gas permeable membrane 2 and/or the support body 3 either directly or via another member. It is preferable that, as shown in Figs. 1A and 1B, the membranous valve 4 be fixed to the gas permeable membrane 2 and/or the support body 3 at a portion of its outer peripheral edge that is in contact with the support body 3 since the durability of the membranous valve 4 is improved.

The membranous valve 4 may be a valve that substantially does not allow gas to permeate therethrough (gas non-permeable valve) or may be such a valve that a region A of the membranous valve 4 that is in contact with the gas permeable membrane 2 has a gas permeable property. However, when the region A has a gas permeable property, the gas permeability of the region A needs to be less than the gas permeability of the gas permeable membrane 2 in order for the membranous valve 4 to serve as an obstruction to the gas permeation in the region α of the gas permeable membrane 2. It is preferable that the membranous valve 4 be a gas non-permeable valve to enlarge the ratio A of gas discharge rate to gas introduction rate.

The term "gas permeability" in the present specification means a quantity represented by "the volume of the gas that permeates through a gas permeable film per unit area of the film and per unit time when a predetermined pressure difference is applied to both sides of the film." The same gas permeability may also be represented by "the pressure loss that is caused when a gas permeates through the just-mentioned film at a predetermined face velocity." Such a gas permeability may be measured using the Frazier air permeability measurement method according to JIS L 1096 (1999).

When the membranous valve 4 is a gas non-permeable valve, the gas permeable area X of the gas permeable membrane 2 with the membranous valve 4 being open (the area that reflects the regions α + β of the gas permeable membrane 2 in the example shown in Fig. 1A) can be made larger than the gas permeable area Y with the membranous valve 4 being closed (the area that reflects the region β of the gas permeable membrane 2 in the example shown in Fig. 1A; in other words, the area of the opening 13 in the surface of the gas permeable membrane 2). In other words, when the membranous valve 4 is a gas non-permeable valve, it can be said that the ventilation member 1 is a ventilation member that can ensure a long time until fogging is produced and also can shorten the time until the produced fogging disappears when the interior of the housing is fogged, by controlling the gas permeable area of the gas permeable membrane 2 for the gas moving from the interior to the exterior of the housing 51 and the gas permeable area of the gas permeable membrane 2 for the gas moving from the exterior to the interior of the housing 51.

The ratio B of the gas permeable area X to the gas permeable area Y (ratio B = "gas permeable area X" / "gas permeable area Y") is not particularly limited. However, it is preferable that the ratio B be 3 or greater, and more preferably 5 or greater, from the viewpoint of maintaining a good balance between the time until fogging is produced and the time until the produced fogging disappears. The upper limit of the ratio B may be, but is not particularly limited to, about 30, for example.

The material for the membranous valve 4 may be a resin or a metal. Examples of the resin include polyolefins such as polyethylene, polyesters such as polyethylene terephthalate (PET) and polybutylene terephthalate (PBT), and fluororesins such as polytetrafluoroethylene (PTFE), as well as polyimides and polyamides. Examples of the metal include aluminum, copper, and stainless steel.

The above-mentioned materials may be formed into a film and processed into a predetermined shape to obtain a gas non-permeable valve.

A valve in which the region A has a gas permeable property may be obtained by forming a film in which a number of pores are formed using, for example, fabric, nonwoven fabric, net, porous material, or foamed material of the foregoing materials and processing the formed film into a predetermined shape. In this case, the gas permeability of the region A can be controlled by adjusting the average pore diameter and/or the porosity thereof. Alternatively, the foregoing materials may be formed into a film in which one or a plurality of through holes is/are formed and processed into a predetermined shape. In this case, the gas permeability of the region A can be controlled by adjusting the ratio of the opening area of the through hole(s) to the area of the region A.

When the membranous valve 4 is a gas non-permeable valve, the gas permeable area X of the gas permeable membrane 2 should preferably be, but is not particularly limited to, 10 mm² to 3000 mm², for example, from the viewpoint of removing the fogging in the housing 51 more quickly and preventing an excessive pressure increase in the housing 51. Likewise, the gas permeable area Y of the gas permeable membrane 2 should preferably be, but is not particularly limited to, from 0.5 mm² to 1000 mm², for example, from the viewpoint of further prolonging the time until fogging is produced in the housing 51.

The material and structure of the gas permeable membrane 2 is not particularly limited as long as a necessary gas permeation quantity can be ensured. For example, it is possible to employ a gas permeable membrane including fabric, nonwoven fabric, net, porous material, or foamed material, for example. Especially, a gas permeable membrane containing a porous fluororesin material and/or a porous polyolefin material is preferable from the viewpoints of water repellency (waterproofness), heat resistance, chemical resistance, and the like. Usable examples of the fluororesin include polytetrafluoroethylene (PTFE), polychloro-trifluoroethylene, tetrafluoroethylene-hexafluoropropylene copolymer, tetrafluoroethylene-pexafluoroalkylvinyl copolymer, tetrafluoroethylene-ethylene copolymer, and polyvinylidene fluoride (PVdF). It is especially preferable to use a PTFE porous material, which is capable of ensuring a gas permeability property with a small gas permeable area and preventing the entry of foreign matter such as water and dust into the housing 51 highly effectively. An ultra high molecular weight polyethylene and the like may be used as the polyolefin.

When using a fluororesin porous material and/or a polyolefin resin porous material as the gas permeable membrane 2, it is preferable that the average pore diameter of the porous material be within the range of from about 0.01 µm to 10 µm from the viewpoint of waterproofness. Such a porous material can be obtained by a common method for forming porous materials, such as a drawing method and an extraction method. The thickness of the gas permeable membrane 2 is usually within the range of from 1 µm to 300 µm, preferably within the range of from 2 µm to 100 µm.

From the viewpoint of removing the fogging in the housing 51 more quickly during discharge of the gas and preventing an excessive pressure rise in the housing 51, the gas permeability of the gas permeable membrane 2 may preferably be, but not particularly limited to, within the range of from 1 Pa to 1000 Pa, and more preferably within the range of from 5 Pa to 500 Pa in terms of the pressure loss when a gas permeates through the gas permeable membrane 2 at a face velocity of 5.3 cm/sec. In the case that there is a possibility that liquid water may come into contact with the gas permeable membrane 2, it is preferable that the water withstanding pressure (the pressure at which liquid water permeates through the gas permeable membrane 2), which is an indicator that indicates the waterproofness of the gas permeable membrane 2, be within the range of from 2 kPa to 1000 kPa, and more preferably within the range of from 3 kPa to 500 kPa.

It is preferable that an outer peripheral edge of the gas permeable membrane 2 be supported by the support body 3, as shown in Figs. 1A and 1B. This allows the fixing of the membranous valve 4 to the support body 3 and/or the gas permeable membrane 2 to be conducted more easily.

The number of layers of the gas permeable membrane 2 is not limited to one layer, and the ventilation member 1 may have any number of layers of the gas permeable membrane 2.

In the ventilation member 1 of the present invention, a reinforcing layer may be stacked on the gas permeable membrane 2. By stacking a reinforcing layer, the strength of the gas permeable membrane 2 can be improved. The advantageous effect is more significant when the thickness of the gas permeable membrane 2 is smaller. The number of layers of the reinforcing layer stacked on the gas permeable membrane 2 may be set as appropriate.

The material and the structure of the reinforcing layer are not particularly limited, but it is preferable that the reinforcing layer have a better gas permeability than the gas permeable membrane. Usable examples of the reinforcing layer include fabric, nonwoven fabric, mesh, net, sponge, foam, foamed material, and porous material, which may be made of, for example, a resin or a metal. Usable examples of the resin include polyolefins such as polyethylene and polypropylene, polyesters such as PET and PBT, polyamides, aromatic polyamides, acrylic resins, polyimides, and composite materials thereof.

The thickness of the reinforcing layer is usually within the range of from 0.05 mm to 0.4 mm, and it is preferable that the thickness of the reinforcing layer be within the range of from 0.05 mm to 0.4 mm, from the viewpoint of obtaining better processability to form the reinforcing layer into a predetermined shape. The gas permeability of the reinforcing layer may be within the range of from 0.5 Pa to 150 Pa in terms of the pressure loss when a gas permeates through the reinforcing layer at a face velocity of 5.3 cm/sec, preferably within the range of from 0.5 Pa to 70 Pa.

The reinforcing layer may be joined to the gas permeable membrane 2. The joining may be performed by such techniques as adhesive lamination, heat lamination, heat-bonding, and ultrasonic welding.

The gas permeable membrane 2 may be a liquid repellent membrane, such as a water repellent membrane or an oil repellent membrane. The liquid repellent membrane may be formed by, for example, applying and drying a substance having a small surface tension to a gas permeable membrane, and thereafter curing the substance. The substance (liquid repellent) used for the liquid repellent treatment may be a solution containing a polymer material having perfluoroalkyl groups, for example. The application of the substance to the gas permeable membrane may be conducted by a common technique, such as an impregnation method or a spraying method.

It is preferable that to use a thermoplastic resin as the material for the support body 3 from the viewpoint of moldability. Examples include various thermoplastic elastomers such as olefin-based, styrene-based, urethane-based, ester-based, amide-based, and vinyl chloride-based thermoplastic elastomers; various thermoplastic resins such as polyolefin, polyamide, polyester, polyacetal, polysulfone, polyacrylic, and polyphenylene sulfide; and composite materials thereof.

The members that are supported by the support body 3 may be fixed to the support body 3 by using such techniques as heat-bonding, ultrasonic welding, and adhesive bonding. Especially, heat-bonding and ultrasonic welding techniques are simple and therefore preferable. When the gas permeable membrane 2 on which the reinforcing layer is stacked is fixed to the support body 3, damages to the gas permeable membrane 2 can be minimized by stacking the reinforcing layer and the gas permeable membrane 2 and thereafter fixing these layers to the support body 3.

In the ventilation member 1 shown in Fig. 1A, the gas permeable membrane 2 is supported directly by the support body 3; however, it is possible to dispose another member between the gas permeable membrane 2 and the support body 3. When this is the case, the gas permeable membrane 2 is supported by the support body 3 via a member that is disposed therebetween.

The shape of the support body 3 is not particularly limited as long as it can be used for the ventilation member 1. The support body 3 may be formed using common molding techniques, such as injection molding and extrusion molding.

Figs. 6A and 6B show a further example of the ventilation member 1 according to the present invention. A ventilation member 1 shown in Figs. 6A and 6B is provided with a gas permeable membrane 2 and a support body 3 for supporting the gas permeable membrane 2. The support body 3 is inserted in and fixed to an opening 52 of a housing 51. A one-way valve 8 is fixed to the gas permeable membrane 2 via a support layer 9 so that portions of its end parts (end part G and end part G' shown in Fig. 6A) are away from the gas permeable membrane 2, and the end part G and the end part G' abut each other. In other words, the one-way valve 8 has a pair of end parts abutting on each other serving as the end part that is away from the gas permeable membrane. The ventilation member 1 is fixed to the housing 51 so that the end parts G and G' of the one-way valve 8 are positioned toward the outside of the housing 51 relative to the portion of the one-way valve 8 that is in contact with the support layer 9. By the pressure P_{A} of the gas that permeates through the gas permeable membrane 2 in a direction from the interior toward the exterior of the housing 51, the end parts G and G' can be deformed in the just-mentioned direction. In the one-way valve 8 shown in Fig. 6A, a slit-shaped opening 13 is formed by the just-mentioned deformation. (See Fig. 6B: For clarity in illustration, Fig. 6B shows the state in which the opening 13 has been formed.)

In the ventilation member 1 shown in Figs. 6A and 6B, the one-way valve 8 serves as an obstruction to the gas permeation in the region α of the gas permeable membrane 2. Here, when the pressure P_{A} becomes equal to or higher than the threshold value P_{T}, the slit-shaped opening 13 is formed and thereby the one-way valve 8 opens in the direction in which the gas permeates through the gas permeable membrane 2 from the interior to the exterior of the housing 51. When the one-way valve 8 opens, the above-mentioned obstruction in the region α is alleviated. The deformation of the end parts G and G' of the one-way valve 8 is reversible. Therefore, when the pressure P_{A} decreases or when the pressure P_{B} of the gas that permeates through the gas permeable membrane 2 in the direction from the exterior to the interior of the housing 51 acts on the one-way valve 8, the one-way valve returns to the state shown in Fig. 6A (i.e., the one-way valve 8 closes).

Thus, employing such a configuration also makes it possible to obtain the same advantageous effects as with the ventilation member 1 shown in Figs. 1A and 1B.

The structure and configuration of the one-way valve 8 of the ventilation 1 are not particularly limited as long as the following conditions are met:
- A portion of the one-way valve 8 is fixed to at least one selected from the gas permeable membrane 2 and the support body 3;
- By the pressure P_{A} of the gas that permeates through the gas permeable membrane 2 in a predetermined one direction, the end part that is away from the gas permeable membrane 2 can be deformed in the one direction; and
- By a decrease of the above-mentioned pressure P_{A} or by the pressure P_{B} of the gas that permeates through the gas permeable membrane 2 in the opposite direction to the above-mentioned one direction, the one-way valve 8 can return to the state before the one-way valve 8 was deformed (that is, the deformation of the one-way valve 8 is reversible).

For example, the one-way valve 8 may have only one end part that is disposed away from the gas permeable membrane 2 and is deformable in the predetermined one direction by the pressure P_{A}, or the one-way valve 8 may have two or more such end parts that are away from each other. When the one-way valve 8 has two or more such end parts abutting on each other, it is preferable that the one-way valve 8 have a pair of such end parts, as shown in Fig. 6A. Such one-way valve 8 shows good operability.

It is preferable that the one-way valve 8 be made of an elastic material. Such a valve has such advantages that various valve shapes can be processed easily and the threshold value P_{T} can be set easily. Moreover, with the one-way valve 8 made of an elastic material, the one-way valve 8 can be kept closed without any force being applied thereto under normal conditions by appropriately adjusting its shape, and therefore the entry of water vapor into the housing 51 under normal conditions can be prevented. Examples of usable elastic materials include rubber, elastomer, and thermoplastic resin.

In the ventilation member 1 shown in Figs. 6A and 6B, the gas permeable area X of the gas permeable membrane 2 with the one-way valve 8 being open (the area that reflects the regions α + β of the gas permeable membrane 2 shown in Fig. 6A) can be made larger than the gas permeable area Y with the one-way valve 8 being closed (the area that reflects the region β of the gas permeable membrane 2 shown in Fig. 6A). In other words, it can be said that the ventilation member 1 shown in Figs. 6A and 6B is a ventilation member that can ensure a long time until fogging is produced and also can shorten the time until the produced fogging disappears when the interior of the housing is fogged, by controlling the gas permeable area of the gas permeable membrane 2 for the gas moving from the interior to the exterior of the housing 51 and the gas permeable area of the gas permeable membrane 2 for the gas moving from the exterior to the interior of the housing 51.

The ratio B of the gas permeable area X to the gas permeable area Y may be the same as the value described above in the description of the ventilation member 1 shown in Figs. 6A and 6B.

The threshold value P_{T} at which the one-way valve 8 deforms can be controlled by adjusting or selecting, for example, the material, dimensions, and/or shape of the one-way valve 8. The values P_{A} and P_{B} at which the one-way valve 8 returns to the state before it deforms can be controlled likewise. It should be noted that the threshold value P_{T} may be a value within a predetermined range, not just at one specified point.

The method for fixing the one-way valve 8 to at least one selected from the gas permeable membrane 2 and the support body 3 is not particularly limited, and the one-way valve 8 may be fixed with the use of such techniques as heat-bonding, ultrasonic welding, and adhesive bonding. As illustrated in Fig. 6A, the one-way valve 8 may be fixed via another member such as the support layer 9. For the support layer 9, the same material as that for the support body 3 may be used, and the structure and configuration thereof are not particularly limited.

In the ventilation member 1, the numbers of the layers of the gas permeable membrane 2 and the one-way valve 8, as well as the positioning relationship between the gas permeable membrane 2 and the one-way valve 8, may be determined as appropriate. When the one-way valve 8 is disposed more outward from the housing 51 than the gas permeable membrane 2 as shown in Figs. 6A and 6B, the one-way valve 8 also serves as a protective cover for protecting a portion of the gas permeable membrane 2.

The ventilation member 1 according to the present invention also may have a multiple-pore body having a smaller gas permeability than the gas permeable membrane 2, and the gas permeable membrane 2 may have a first region in which a one-way valve (such as the membranous valve 4 or the one-way valve 8) is disposed and a second region in which the multiple-pore body is disposed. Figs. 7A and 7B illustrate one example of such a ventilation member 1.

A ventilation member 1 shown in Figs. 7A and 7B further has a multiple-pore body 5 that has a smaller gas permeability than the gas permeable membrane 2 and is disposed in contact with the surface of the gas permeable membrane 2. The gas permeable membrane 2 has a region γ in which a membranous valve 4 is disposed, and a region δ in which the multiple-pore body 5 is disposed. The multiple-pore body 5 is a membrane that has a plurality of through holes 6. It can be said that the multiple-pore body 5 is disposed in the opening of the gas permeable membrane 2. By employing such a configuration, the gas introduction rate can be reduced further (i.e., the ratio A of the gas discharge rate to the gas introduction rate can be increased further) than the case in which the multiple-pore body 5 is not disposed.

When the gas introduction rate is reduced, the time until fogging is produced can be prolonged further while the time until the fogging produced in the housing can be removed is kept. In the case of the ventilation member 1 as shown in Figs. 1A and 1B, in which the multiple-pore body 5 is not provided, it is necessary to shorten the length of the inner peripheral edge (end part B) of the membranous valve 4 in order to reduce the gas introduction rate, and consequently, it may become difficult for the end part B to be detached away from the surface of the gas permeable membrane 2. In contrast, the ventilation member 1 shown in Figs. 7A and 7B enables the gas introduction rate to be reduced further without shortening the length of the inner peripheral edge, that is, while maintaining the operability of the membranous valve 4.

The structure and configuration of the multiple-pore body 5 are not particularly limited as long as the necessary gas permeability can be achieved. The multiple-pore body 5 may be one in which one or a plurality of through holes 6 is formed as illustrated in Fig. 7B, or the multiple-pore body 5 may be one in which a number of pores are formed, such as a fabric, a nonwoven fabric, a net, a foamed material, and a porous material. The gas permeability of the multiple-pore body 5 may be, for example, within the range of from about 1% to 100% with respect to the gas permeability of the gas permeable membrane 2, preferably within the range of from 5% to 50%.

In the case of the multiple-pore body 5 in which through holes 6 are formed, the gas permeability of the multiple-pore body 5 can be controlled by adjusting the number of the through holes 6 or adjusting the ratio of the opening area of the through holes 6 to the area of the surface of the multiple-pore body 5. The just-mentioned ratio may be from about 1% to about 50%, preferably within the range of from 2% to 30%. In the case of the the multiple-pore body 5 in which a number of pores are formed, the gas permeability of the multiple-pore body 5 can be controlled by adjusting the average pore diameter and/or the porosity thereof.

The material used for the multiple-pore body 5 is not particularly limited and may be the same material as used for the gas permeable membrane 2. The simplest example of the multiple-pore body 5 may be made by preparing an adhesive tape and forming one or a plurality of through holes 6 in the tape. When an adhesive tape is used for the multiple-pore body 5, good productivity of the ventilation member 1 is achieved because good bondability is obtained between the ultiple-pore body 5 and the gas permeable membrane 2 and the through holes 6 can be formed easily with a punch or the like. The type of adhesive tape is not particularly limited, and the adhesive tape may be one in which an adhesive material such as rubber-based, acryl-based, or silicone-based adhesive material is coated on a base material made of polyester, polyolefin, polyimide, fluororesin, or the like.

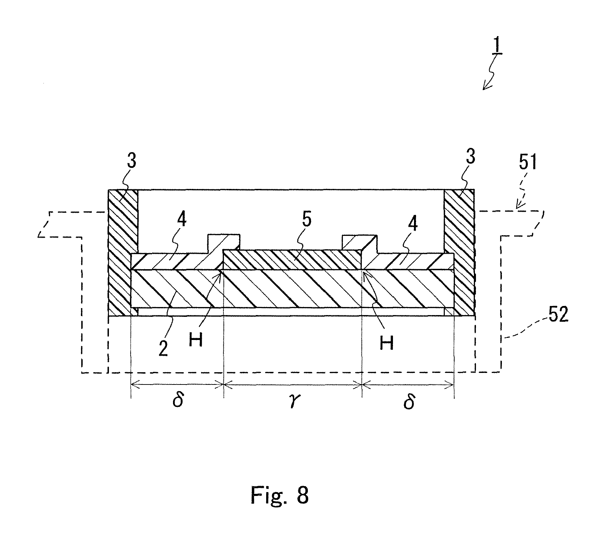

The shape of the multiple-pore body 5, and the shape of the membranous valve 4 when the multiple-pore body 5 is disposed, may be determined freely. As shown in Figs. 7A and 7B, the multiple-pore body 5 may have a shape such as to complement the membranous valve 4 in the surface of the gas permeable membrane 2, or as shown in Fig. 8, the membranous valve 4 and the multiple-pore body 5 may be stacked partially in a direction perpendicular to the primary surface of the gas permeable membrane 2 (in the ventilation member 1 shown in Fig. 8, the membranous valve 4 opens when an end part H of the membranous valve 4 is detached away from the surface of the gas permeable membrane 2). As shown in Figs. 9A and 9B, a gap may exist between the membranous valve 4 and the multiple-pore body 5 in the surface of the gas permeable membrane 2.

In the ventilation member 1 according to the present invention, a member 7 that substantially does not allow gas to permeate therethrough may be provided in place of, or in addition to, the multiple-pore body 5. The member 7 serves as a member that restricts the gas permeability of the region of the gas permeable membrane 2 in which the one-way valve is not disposed (Figs. 10A and Fig. 10B). The member 7 may be disposed in a similar manner to the multiple-pore body 5, but in order to allow gas to permeate through the gas permeable membrane 2 even when the one-way valve (the membranous valve 4 in the example shown in Fig. 10A) is closed, it is necessary that a gap exist between the one-way valve and the member 7 so that at least a portion of the surface of the gas permeable membrane 2 is in communication with the environment outside the housing 51. Such a ventilation member 1 can obtain the same advantageous effects as in the case where the multiple-pore body 5 is provided.

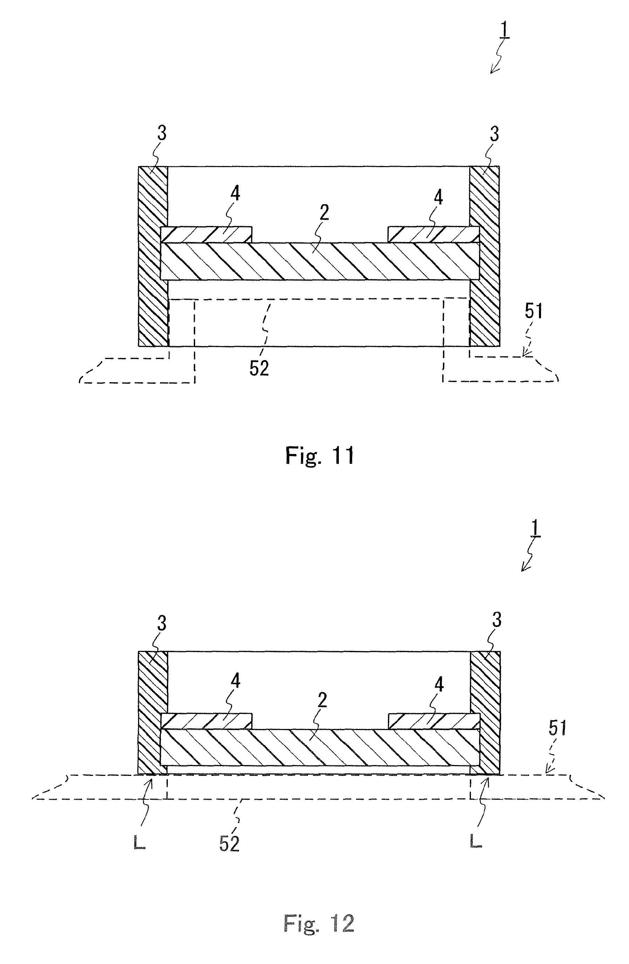

The method for fixing the ventilation member 1 to the opening 52 of the housing 51 is not particularly limited, and common fixing methods may be employed. As illustrated in Fig. 1A, the ventilation member 1 may be fixed by inserting it into the opening 52, or as illustrated in Fig. 11, the ventilation member 1 may be fixed so as to cover the opening 52. When the ventilation member 1 is fixed by inserting it into the opening 52, it is preferable that the outer diameter of the support body 3 be slightly larger than the inner diameter of the opening 52. When the ventilation member 1 is fixed so as to cover the opening 52, it is preferable that the inner diameter of the support body 3 be slightly smaller than the outer diameter of the opening 52. As shown in Fig. 12, it is also possible to fix the ventilation member 1 and the housing 51 by adhesive bonding. In the example shown in Fig. 12, a bottom face (denoted as L in Fig. 12) of the ventilation member 1 and a surface of the housing 51 are adhesive-bonded so as to cover the opening 52 of the housing 51.

When fixing the ventilation member 1 according to the present invention to the housing 51, it is necessary to match the direction in which at least a portion of an end part of the one-way valve (for example, the membranous valve 4 or the one-way valve 8) provided for the ventilation member 1 is deformed (i.e., the direction in which the one-way valve opens) and the direction in which a gas passes from the interior to the exterior of the housing 51.

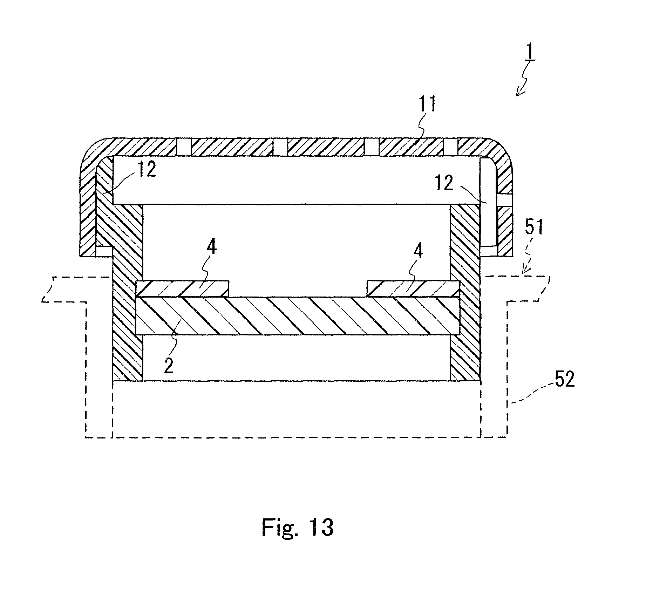

The ventilation member 1 according to the present invention may further have a closed-bottomed protective cover 11 that covers the gas permeable membrane 2, as illustrated in Fig. 13. The protective cover 11 shown in Fig. 13 is supported by the support body 3 so that a space gap is present between the gas permeable membrane 2 and the protective cover 11 to ensure a gas passage from the external environment to the gas permeable membrane. In such a ventilation member, the protective cover 11 hinders foreign matters from the exterior, such as stone chips, dust, and water, from making contact with the gas permeable membrane and thus protects the gas permeable membrane 2 against breakage.

The shape of the protective cover 11 and the method for supporting the protective cover 11 by the support body 3 are not particularly limited. In the ventilation member 1 shown in Fig. 13, a protrusion portion 12 that is formed on the support body 3 supports the protective cover 11 and ensures the gas passage connecting the external environment to the gas permeable membrane 2.

The structure and the configuration of the ventilation member 1 according to the present invention are not limited to the foregoing examples. For example, the ventilation member 1 may be provided with both the membranous valve 4 and the one-way valve 8, or may be provided with any desired members other than the above-described members.

Next, the following describes a vented housing according to the present invention.

A vented housing according to the present invention is characterized in that a ventilation member 1 according to the present invention is fixed to an opening of the housing. As a result, the vented housing can ensure a long time until fogging is produced in the housing and also can shorten the time until the produced fogging disappears when the interior of the housing is fogged.

The type of the vented housing in which a ventilation member according to the present invention is fixed is not particularly limited. Examples include electrical components such as headlamps, tail lamps, fog lamps, turn indicator lamps, reversing lamps, motor housings, pressure sensors, pressure switches, and ECUs, as well as housings for electric appliances such as mobile telephones, cameras, electric shavers, electric toothbrushes, and lamps. In particular, the advantageous effects obtained are significant when the vented housing is an automobile electrical component, such as an automobile lamp.

### EXAMPLES

Hereinbelow, the present invention will be described in detail with reference to examples. It should be noted, however, that the invention is not limited by the following examples.

In the present examples, seven types of ventilation members were fabricated, each of which was as shown in Figs. 7A and 7B or Figs. 9A and 9B and had a gas permeable membrane 2, a membranous valve 4 having gas non-permeability, and a multiple-pore body 5. Each sample of the ventilation members was fixed to a housing, and thereafter, the time until fogging was produced in the housing and the time until the produced fogging disappeared were evaluated. In each of the samples, the size and the shape of the membranous valve 4 were constant, but by varying the diameter of the multiple-pore body 5 and the area of the opening of the through holes 6, the gas permeable area X of the gas permeable membrane 2 with the membranous valve 4 being open and the gas permeable area Y of the gas permeable membrane 2 with the membranous valve 4 being closed were varied.

A manufacturing method for each sample of the ventilation members is shown below.

First, a paste obtained by kneading 100 parts by weight of PTFE fine powder and 30 parts by weight of liquid paraffin as a liquid lubricant was preformed and thereafter formed into a round rod shape by paste extrusion, to obtain a PTFE formed body. Next, the resultant formed body was roll-pressed, and the liquid paraffin contained in the formed body was removed by extraction using normal decane, to obtain a 0.2 mm-thick PTFE roll-pressed sheet. Next, the obtained roll-pressed sheet was drawn in its longitudinal direction (drawing temperature: 300°C, draw ratio: 20 times), and thereafter, the sheet further was drawn in its width direction (drawing temperature: 100°C, draw ratio: 30 times), to form a PTFE porous material (thickness: 5 µm, withstanding water pressure: 5kPa, and pressure loss at a permeating gas face velocity of 5.3 cm/sec: 40 Pa). The PTFE porous material thus prepared was punched out into a circular shape having a diameter of 10 mmø, to form the gas permeable membrane 2.

Next, the membranous valve 4 was formed separately from the gas permeable membrane 2 in the following manner. First, a PTFE dispersion (solid content: 60 weight %, PTFE average particle diameter: 0.3 µm, surface tension at 23°C: 31.5 mN/m, viscosity: 25 mPa•sec) was impregnated in an aluminum foil by a dipping method. Then, a drying process at 80°C for 3 minutes and then at 380°C for 2 minutes was repeated three times, and thereafter, the resultant was peeled off from the aluminum foil, to obtain a PTFE film. The PTFE film thus prepared was punched out into a doughnut shape having an outer diameter of 10 mmø and an inner diameter of 5 mmø, to form the membranous valve 4.

The gas permeable membrane 2 and the valve 4 prepared in this manner were adhesive-bonded and fixed to a support body 3 made of PBT using a commercially available instant adhesive. Thereafter, an adhesive tape (base material: PET with a thickness of 25 µm, adhesive material: silicone-based adhesive (SH4280 made by Dow Corning Toray Co., Ltd.) in which a plurality of through holes 6 were formed by a punch, serving as the multiple-pore body 5, further was bonded onto the surface of the gas permeable membrane 2, to prepare a ventilation member 1 (sample 1) as shown in Figs. 7A and 7B. The gas permeable area Y of the gas permeable membrane 2 in the sample 1 was 0.02 cm², and the gas permeable area X thereof was 0.6 cm².

Samples 2 to 5 were produced in a similar manner to that used for the sample 1. It should be noted, however, that the diameter of the multiple-pore body 5 and the area of the opening of the through holes 6 were varied so that the gas permeable area X and/or the gas permeable area Y of the gas permeable membrane 2 was/were varied (see Table 1 below).

Sample A, a comparative example, was produced in the same manner as in the sample 1, except that, after the gas permeable membrane 2 and the membranous valve 4 were fixed to the support body 3, the entire membranous valve 4 was further adhesive-bonded to the gas permeable membrane 2. This means that, in the sample A, the valve 4 cannot be detached away from the gas permeable membrane 2, so the gas permeable area of the gas permeable membrane 2 in the sample A is 0.02 cm² at all times.

Sample B, another comparative example, was produced, in which the membranous valve 4 and the multiple-pore body 5 were not provided and only the gas permeable membrane 2 prepared in the above-described manner was fixed to the support body 3. The gas permeable area of the gas permeable membrane 2 in the sample B is 0.6 cm² at all times.

The embodiment samples 1-5 and comparative example samples A-B were fixed to respective housings, and for each sample, the time until fogging is produced in the housing and the time until the produced fogging disappears were evaluated. The evaluation methods for each of the times are described below.

First, transparent cubic containers (15 cm side) made of acrylic resin were prepared as the housings, and an opening having a diameter of 10mmø was formed in each of the prepared housings. Thereafter, these housings were kept in a dryer at 40°C for 24 hours to dry the interior of the housing completely. Next, while the housings were being kept in the dry atmosphere, each of the samples of the ventilation members prepared in the above-described manners was bonded and fixed to the opening of each respective one of the housings using a double-sided tape, as illustrated in Fig. 11.

Next, the housings to which the ventilation members had been fixed were accommodated in a thermo-hygrostat chamber kept at a temperature 25°C and a relative humidity (RH) of 65%. Each of the housings was taken out of the thermo-hygrostat chamber 3 hours later, 6 hours later, and 12 hours later after they had been placed into the chamber, and the surface of the housing that was opposite to the surface to which the ventilation member had been fixed was immersed in a water tank that was kept at 5°C for 5 minutes, to confirm whether fogging was produced in the housing. The housings in which fogging had been produced thereafter were placed in an atmosphere at a temperature of 40°C and a relative humidity (RH) of 65%, and the time until the fogging produced in the housing disappeared was measured.

The results of the evaluation are shown in Table 1 below.

**[TABLE 1]**

| Sample No. | 1 | 2 | 3 | 4 | 5 | A (Comparative Example) | B (Comparative Example) |
|---|---|---|---|---|---|---|---|
| Gas permeable area Y of gas permeable film 2 (cm²) | 0.02 | 0.02 | 0.02 | 0.6 | 0.2 | 0.02 | 0.6 |
| Gas permeable area X of gas permeable film 2 (cm²) | 0.6 | 0.3 | 0.1 | 1 | 0.6 | | |
| Time until fogging is produced (hours) | 12 | 12 | 12 | 3 | 6 | 12 | 3 |
| Time until fogging disappears (minutes) | 3 | 8 | 18 | 1 or less | 3 | 45 | 3 |

As shown in Table 1, each of the samples 1 to 5 was capable of ensuring a long time until fogging is produced in the housing and also shortening the time until the fogging produced in the housing disappears, in comparison with the samples A and B.

The present invention is applicable to various other embodiments unless they depart from the intentions and the essential features of the invention. The embodiments disclosed herein are purely illustrative and not in any sense limiting. The scope of the invention is defined by the appended claims, not by the description, and all the modifications and equivalents to the claims are intended to be included within the scope of the invention.

### INDUSTRIAL APPLICABILITY

The present invention can provide a ventilation member that can ensure a long time until fogging is produced in the housing and also can shorten the time until the produced fogging disappears when the interior of the housing is fogged.

The ventilation member according to the present invention may be used for various housings without any particular limitations. Examples of the vented housing using the ventilation member according to the present invention include automobile lamps such as headlamps, tail lamps, fog lamps, turn indicator lamps, and reversing lamps; automobile electrical components such as motor housings, pressure sensors, pressure switches, and ECUs; and electric appliances such as mobile telephones, cameras, electric shavers, electric toothbrushes, indoor lamps, and outdoor lamps.

## Claims

1. A ventilation member comprising:
a gas permeable membrane, fixed to an opening of a housing, for allowing gas passing through the opening to permeate therethrough;
a support body for supporting the gas permeable membrane; and
a one-way valve disposed so as to serve as an obstruction to permeation of the gas in a partial region of the gas permeable membrane, wherein:
a portion of the one-way valve is fixed to at least one selected from the gas permeable membrane and the support body;
a portion of an end part of the one-way valve is deformable in a predetermined one direction by a pressure of the gas that permeates through the gas permeable membrane in the one direction;
the deformation of the at least a portion of the end part is reversible; and
when the at least a portion of the end is deformed in the one direction, the obstruction to the permeation of the gas by the one-way valve is alleviated.

2. The ventilation member according to claim 1, wherein:
the one-way valve is a membranous valve disposed in contact with a surface of the gas permeable membrane so as to cover a portion of the gas permeable membrane; and
at least a portion of an end of the membranous valve is capable of being detached away from the surface of the gas permeable membrane by the pressure of the gas that permeates therethrough in the one direction.

3. The ventilation member according to claim 2, wherein:
the gas permeable membrane is supported by the support body at an outer peripheral edge of the gas permeable membrane;
the membranous valve is fixed to at least one selected from the support body and the gas permeable membrane, at an outer peripheral edge of the membranous valve that is in contact with the support; and
an inner peripheral edge of the membranous valve is capable of being detached away from the surface by the pressure of the gas that permeates through the gas permeable membrane in the one direction.

4. The ventilation member according to claim 3, wherein the membranous valve is disposed so that an opening surrounded by the membranous valve is formed in a surface of the gas permeable membrane.

5. The ventilation member according to claim 2, wherein the membranous valve substantially does not allow gas to permeate therethrough.

6. The ventilation member according to claim 1, wherein:
the one-way valve is disposed in such a state that a portion of an end part of the one-way valve is away from the gas permeable membrane; and
the end part that is away from the gas permeable membrane is capable of being deformed in the one direction by the pressure of the gas that permeates through the gas permeable membrane in the one direction.

7. The ventilation member according to claim 6, wherein the one-way valve is made of an elastic material.

8. The ventilation member according to claim 6, wherein:
the one-way valve comprises a pair of end parts abutting each other as the end part that is away from the gas permeable membrane;
the pair of end parts is capable of being deformed in the one direction by the pressure of the gas that permeates through the gas permeable membrane in the one direction; and
a slit-shaped opening is formed by the deformation.

9. The ventilation member according to claim 1, further comprising:
a multiple-pore body having a smaller gas permeability than the gas permeable membrane, and
wherein the gas permeable membrane has a first region in which the one-way valve is disposed and a second region in which the multiple-pore body is disposed.

10. The ventilation member according to claim 9, wherein the multiple-pore body is disposed in contact with a surface of the gas permeable membrane.

11. The ventilation member according to claim 1, wherein the gas permeable membrane includes a porous fluororesin membrane.

12. The ventilation member according to claim 11, wherein the fluororesin is polytetrafluoroethylene.

13. The ventilation member according to claim 1, wherein the gas permeable membrane includes a porous polyolefin membrane.

14. A vented housing, having an opening for allowing gas to pass therethrough, comprising:
a ventilation member according to claim 1, wherein
the ventilation member is fixed to the opening in such a manner that the direction in which at least a portion of an end part of the one-way valve of the ventilation member is deformed is a direction in which the gas passes from an interior to an exterior of the housing.
